# EUROPEAN PATENT SPECIFICATION

(11) **EP 1 386 949 B1**
(45) Date of publication and mention of the grant of the patent: **14.01.2009**
(21) Application number: 03017358.7
(22) Date of filing: 31.07.2003
(51) Int. Cl.: C09G 1/02, C09K 3/14

(54) **Use of an aqueous dispersion for chemical mechanical polishing and process for producing a semiconductor device**
Verwendung einer wässrigen Dispersion zum chemisch-mechanischen Polieren und Verfahren zur Herstellung einer Halbleiteranordnung
Utilisation d'une dispersion aqueuse pour le polissage chimico-mécanique et procédé de fabrication d'un dispositif semi-conducteur

(30) Priority: 02.08.2002 JP 2002225906
(43) Date of publication of application: 04.02.2004
(73) Proprietor: JSR Corporation, Tokyo 104-0045 (JP)
(72) Inventor: Konno, Tomohisa, c/o JSR Corporation, Tokyo 104-0045 (JP); Motonari, Masayuki, c/o JSR Corporation, Tokyo 104-0045 (JP); Hattori, Masayuki, c/o JSR Corporation, Tokyo 104-0045 (JP); Kawahashi, Nobuo, c/o JSR Corporation, Tokyo 104-0045 (JP)
(74) Representative: TBK-Patent

(56) References cited:
- EP-A- 1 088 869
- EP-A- 1 104 778
- EP-A- 1 333 476

## Description

### BACKGROUND OF THE INVENTION

### Technical Field of the Invention:

The present invention relates to the use of an aqueous dispersion for chemical mechanical polishing and a production process of a semiconductor device making use of this aqueous dispersion, and particularly to the use of an aqueous dispersion for chemical mechanical polishing that is useful in a polishing treatment of semiconductor substrates, in which an inter layer dielectrics low in dielectric constant exists, in a treatment process that a semiconductor substrate such as a wafer provided with a wiring pattern is subjected to chemical mechanical polishing (hereinafter may referred to as "CMP") in the production of semiconductor devices, particularly useful in a second polishing treatment step in a two-step polishing process or a second polishing treatment step in a three-step polishing process, and a production process of a semiconductor device making use of this aqueous dispersion.

### Description of the Background Art:

A silicon oxide film (SiO₂ film) formed by a vacuum process such as chemical vapor deposition (CVD) has heretofore been often used as an inter layer dielectrics in a semiconductor device or the like. This SiO₂ film is relatively high in dielectric constant.

On the other hand, for the purpose of improving the performance of ultra LSI, attention has been paid to the formation of an inter layer dielectrics having a lower dielectric constant in recent years. In order to achieve this formation of the inter layer dielectrics lower in dielectric constant, an inter layer dielectrics composed of a polymer obtained by plasma-polymerizing a silicon-containing compound such as an alkoxysilane, silane, alkylsilane, arylsilane, siloxane or alkylsiloxane in the presence of oxygen, carbon monoxide, carbon dioxide, nitrogen, argon, H₂O, ozone, ammonia or the like and an inter layer dielectrics composed of polysiloxane, polysilazane, poly(arylene ether), polybenzoxazole, polyimide, silsesquioxane or the like have been developed as substitutes for the SiO₂ film.

Since these dielectrics are low in mechanical strength, soft and brittle compared with the SiO₂ film, however, a semiconductor substrate that is an article to be polished may possibly cause scratches or peeling when a conventional aqueous dispersion for chemical mechanical polishing containing inorganic particles is used. In addition, since a great number of scratches of various shapes may be caused in some cases, a problem arises in the yield of products.

In chemical mechanical polishing for forming a damascene wiring, it is hard to polish a barrier metal film composed of a metal having high hardness such as tantalum with high efficiency. On the other hand, since a copper film for forming a wiring portion is relatively soft and easily polished, dishing may be caused in the wiring portion in some cases to fail to obtain a planarized polished surface. In a porous dielectrics low in dielectric constant in particular, it may be impossible in some cases to form a good damascene wiring because the dielectrics is overpolished.

Although polishing processes for forming a damascene wiring are various, a two-step polishing treatment comprising of a first polishing treatment step, in which polishing of a copper film is mainly conducted, and a second polishing treatment step, in which polishing of a barrier metal film is mainly conducted, is generally preferably performed. Either of the first polishing treatment step and the second polishing treatment step may be conducted with operations devided into two or more. Further, in the first polishing treatment step in this two-step polishing treatment, there are a case where polishing is conducted until the copper film is being almost completely removed and a case where the substrate to be polished is subjected to the second polishing treatment step while the removal of the copper film by the polishing is not completed. Therefore, in the second polishing treatment step, an aqueous dispersion for polishing that is different in components contained from that used in the first polishing treatment step may be used according to polishing conditions applied in the first polishing treatment step.

In each of a plurality of polishing treatment steps conducted under such different conditions as described above, it is general to use an aqueous dispersion for polishing suitable for the purpose of such a polishing treatment step, in other words, an aqueous dispersion for polishing different in composition from that other polishing treatment steps. Accordingly, it has been necessary to provide a number of aqueous dispersions for polishing according to the number of objects of polishing.

On the other hand, any aqueous dispersion for chemical mechanical polishing, by which occurrence of scratches in a surface to be polished in an article, on which an inter layer dielectrics low in mechanical strength and dielectric constant has been formed, is prevented, has not been proposed.

EP-A-1,333,476 discloses an aqueous dispersion for chemical mechanical polishing comprising abrasive grains including inorganic particles, organic particles or organic-inorganic particles. EP-A-1,104,778 discloses processes for producing a composited particle for chemical mechanical polishing and an aqueous dispersion containing this composited particle. By such aqueous dispersions, copper films may be polished. EP-A-1,088,869 discloses an aqueous dispersion for chemical mechanical polishing, comprising abrasive particles, an amphiphatic compound and water.

### SUMMARY OF THE INVENTION

The present invention has been made for the purpose of solving the above-described problems involved in the prior art and has as its first object the use of an aqueous dispersion for chemical mechanical polishing, by which occurrence of scratches in a polished surface is greatly prevented even when it is used in a polishing treatment of an article to be polished composed of a semiconductor substrate having an inter layer dielectrics low in mechanical strength and dielectric constant, a ratio of the removal rate of a copper film to the removal rate of a barrier metal film can be easily controlled with a great degree of freedom though basic components are the same thereby both copper film and barrier metal film can be polished with high efficiency, and a sufficiently planarized finished surface with high precision can be provided without overpolishing the dielectrics.

It is the second object of the present invention to provide a production process of a semiconductor device including a polishing treatment step using the above-described aqueous dispersion for chemical mechanical polishing.

According to the present invention, there is thus provided the use of an aqueous dispersion for chemical mechanical polishing comprising abrasive grains, wherein the abrasive grains include:
(A) simple inorganic particles and
(B) composite particles obtained by integrally combining organic particles with inorganic particles, for polishing a barrier metal film in chemical mechanical polishing.

In the aqueous dispersion used for chemical mechanical polishing according to the present invention, it is preferable that the overall content of all the abrasive grains be 0.11 to 20 % by mass, the content of the simple particles (A) be 0.1 to 19.99 % by mass, and the content of the composite particles (B) be 0.01 to 19.9 % by mass.

In the aqueous dispersion used for chemical mechanical polishing according to the present invention, a value of a specific removal rate ratio (RBM/RCu) represented by a ratio of the removal rate (RBM) of a barrier metal film to the removal rate (RCu) of a copper film in the case where the copper film and barrier metal film are polished under the same conditions may be 0.5 to 200.

In the aqueous dispersion used for chemical mechanical polishing according to the present invention, the value of the specific removal rate ratio (RBM/RCu) may be controlled to 10 to 200. In the aqueous dispersion for chemical mechanical polishing according to the present invention, the value of the specific removal rate ratio (RBM/RCu) may also be controlled to 0.5 to 3.

According to the present invention, there is also provided a process for producing a semiconductor device, comprising the step of polishing a surface to be polished of a semiconductor material including a barrier metal film with the aqueous dispersion for chemical mechanical polishing described above to mainly polish said barrier metal film

according to an embodiment of the present invention, there is further provided a process for producing a semiconductor device, comprising a first polishing treatment step of mainly polishing a copper film of a surface to be polished in a semiconductor material and a second polishing treatment step of mainly polishing a barrier metal film with the aqueous dispersion for chemical mechanical polishing that the value of the specific removal rate ratio (RBM/RCu) is 10 to 200 or 0.5 to 3, conducted after the first polishing treatment step.

According to the aqueous dispersion used for chemical mechanical polishing of the present invention, occurrence of scratches in a polished surface is greatly prevented even when it is used in a polishing treatment of an article to be polished composed of a semiconductor substrate having an inter layer dielectrics low in mechanical strength and dielectric constant, a ratio of the removal rate of a copper film to the removal rate of a barrier metal film can be easily controlled with a great degree of freedom thereby both copper film and barrier metal film can be polished with high efficiency, and a sufficiently planarized finished surface with high precision can be provided without overpolishing the dielectrics.

According to the production process of a semiconductor device of the present invention, occurrence of scratches in a polished surface in a polishing treatment is greatly prevented even with a semiconductor substrate having an inter layer dielectrics low in mechanical strength and dielectric constant, both copper film and barrier metal film can be polished with high efficiency, and a sufficiently planarized finished surface with high precision can be provided without overpolishing the dielectrics.

### DETAILED DESCRIPTION OF THE PREFERRED EMBODIMENTS

The aqueous dispersions used for chemical mechanical polishing according to the present invention will hereinafter be described specifically.

The aqueous dispersions (hereinafter also referred to as polishing slurries or polishing slurry) for chemical mechanical polishing are in a form of a slurry containing abrasive grains in a state dispersed in an aqueous medium. The abrasive grains comprise the following both components:
(A) simple inorganic particles and
(B) composite particles obtained by integrally combining organic particles with inorganic particles, for polishing a barrier metal film in chemical mechanical polishing.

The respective components of the abrasive grains will hereinafter be described.

### (A) Simple particles:

The polishing slurry used according to the present invention contains simple particles composed of inorganic particles.

As examples of the inorganic particles used as the simple particles, may be mentioned particles of silicon dioxide, aluminum oxide, cerium oxide, titanium oxide, zirconium oxide, silicon carbide, silicon nitride, manganese oxide and the like. Among these, particles of silicon dioxide are preferred.

As specific examples of the silicon dioxide particles, may be mentioned fumed silica synthesized by a fumed process, in which silicon chloride or the like is reacted with oxygen and hydrogen in a vapor phase, colloidal silica synthesized by a sol-gel process, in which a metal alkoxide is hydrolyzed and condensed, and colloidal silica synthesized by an inorganic colloid process, in which impurities are removed by purification.

The colloidal silica synthesized by the sol-gel process or colloid process is present in an aqueous medium, in a state that primary particles have associated or aggregated, i.e., in a state of secondary particles, when the particle diameter thereof is comparatively small. The inorganic particles in such a state preferably have an average particle diameter of 1 to 3,000 nm, more preferably 2 to 1,000 nm in terms of primary particles.

The average particle diameter of the secondary particles is preferably 5 to 5,000 nm, more preferably 5 to 3,000 nm, particularly preferably 10 to 1,000 nm. If inorganic particles, the average particle diameter of the secondary particles of which is smaller than 5 nm, are used, the resulting polishing slurry cannot achieve a sufficiently high removal rate in some cases. On the other hand, in a polishing slurry using inorganic particles, the average particle diameter of the secondary particles of which exceeds 5,000 nm, the prevention of dishing and erosion may become insufficient in some cases and further, surface defects such as scratches may be liable to occur. In addition, the polishing slurry may become low in stability.

The average particle diameter of the primary particles can be calculated out from the measurement of the specific surface area of the intended particles and observation through a transmission type electron microscope, and the like. The average particle diameter of the secondary particles can be determined by measurement by means of a laser scattering diffraction measuring device, or the like.

On the other hand, inorganic particles such as silica synthesized by the fumed process are produced in the form of secondary particles, and it is very difficult to disperse them in a state of primary particles in an aqueous medium, and so such particles are present as secondary particles obtained by aggregation of primary particles. Accordingly, the inorganic particles composed of the silica synthesized by the fumed process are sufficiently identified so far as the secondary particles thereof are defined.

The average particle diameter of the secondary particles of the inorganic particles formed of fumed silica are preferably 10 to 10,000 nm, more preferably 20 to 7,000 nm, particularly preferably 50 to 5,000 nm. By using the inorganic particles formed of fumed silica, the average particle diameter of the secondary particles of which falls within this range, there can be provided a polishing slurry which can achieve high removal rate, sufficiently prevents dishing and erosion and is high in stability.

As examples of the organic particles used as the simple particles in the present invention, may be mentioned polymer particles respectively composed of (1) polystyrene and styrene copolymers, (2) (meth)acrylic polymers and (meth)acrylic copolymers such as polymethyl methacrylate, (3) polyvinyl chloride, polyacetal, saturated polyester, polyamide, polyimide, polycarbonate and phenoxy resins, and (4) polyolefins and olefin copolymers such as polyethylene, polypropylene, poly(1-butene) and poly(4-methyl-2-pentene), and other thermoplastic resins.

These organic particles can be prepared by a method of an emulsion polymerization process, suspension polymerization process, emulsion dispersion polymerization process, grinding a resin obtained by bulk polymerization process or the like, or other methods. The organic particles may also be particles of a copolymer having a crosslinked structure obtained by a copolymerization with a crosslinkable monomer such as divinylbenzene or ethylene glycol in the above-described polymerization process.

The organic particles used as the simple particles are preferably particles of a resin selected from (1) polystyrene and styrene copolymers and (2) (meth)acrylic polymers and (meth)acrylic copolymers such as polymethyl methacrylate among the resin mentioned above, and their copolymers having a crosslinked structure.

Almost all of the such organic particles as described above generally present as single particles in the polishing slurry. The average particle diameter of these organic particles is preferably 10 to 5,000 nm, more preferably 15 to 3,000 nm, particularly preferably 20 to 1,000 nm. By using the organic particles having an average particle diameter within this range as the simple particles, there can be provided a polishing slurry which can achieve high removal rate, sufficiently prevents dishing and erosion and is high in stability.

### (B) Composite particles:

The composite particles (B) are contained in the polishing slurry according to the present invention as particles making up the abrasive grains together with the simple particles (A).

In the present invention, as specific examples of the composite particles, may be mentioned inorganic organic composite particles obtained by integrally combining organic particles with inorganic particles, and modified particles obtained by bonding a modifying substance to surfaces of organic particles.

The composite particles composed of the inorganic organic composite particles are those obtained by integrally combining organic particles with inorganic particles in the extent that these particles are not easily separated. No particular limitation is imposed on the kinds of these organic particles and inorganic particles. For example, the same organic particles and inorganic particles as those forming the simple particles described above may be used.

No particular limitation is also imposed on the specific structure of the composite particles. For example, those obtained by combining the organic particles composed of polymer particles with the inorganic particles by a proper method are preferably used.

More specifically, particles in a state that organic particles and inorganic particles, which are different in polarity of zeta potential from each other, have been combined by electrostatic force in, for example, an aqueous medium may be used as the composite particles.

The zeta potential of the organic particles is often negative in the whole pH range or a wide pH range exclusive of a low pH range. In particular, organic particles composed of a polymer having a carboxyl group, sulfonic group or the like surely have a negative zeta potential, and organic particles composed of a polymer having an amino group or the like have a positive zeta potential in a specific pH range.

On the other hand, the zeta potential of the inorganic particles have high dependency on pH, and some inorganic particles have an isoelectric point, at which a zeta potential is zero, at a characteristic pH. In such inorganic particles, the polarity of the zeta potential thereof is reversed before and after this point.

Therefore, a specific kind of organic particles are combined with a specific kind of inorganic particles, and both particles are mixed in such a pH range that their zeta potentials become reverse polarities to each other, whereby inorganic organic composite particles in a state that such organic particles and inorganic particles have been integrally combined by electrostatic force can be obtained.

Even when the zeta potentials of organic particles and inorganic particles mixed are the same polarity upon mixing, inorganic organic composite particles in a state that the organic particles and inorganic particles have been integrally combined can also be obtained by changing the pH after the mixing to create a state that the zeta potentials thereof become reverse polarities to each other.

In the present invention, the composite particles may be modified organic particles in a state that a proper modifying substance has been bonded to the surfaces of organic particle composed of, for example, polymer particles. As examples of the polymer particles, may be mentioned particles of polystyrene and polymethyl methacrylate. The polymer particles, to which the modifying substance has been bonded, can be obtained by, for example, a method in which a reactive material for modifying substance, such as an alkoxysilane, aluminum alkoxide or titanium alkoxide, is polycondensed in the presence of the polymer particles to form the modifying substance on the surfaces of the polymer particles.

When the material for the modifying substance is an alkoxysilane, modified organic particles that polysiloxane is bonded to the surfaces of the polymer particles can be obtained. When the material for the modifying substance is an aluminum alkoxide or titanium alkoxide, modified organic particles that an aluminum or titanium atom is bonded to the surfaces of the polymer particles through a siloxane bond can be obtained. In the method described above, the surfaces of the polymer particles may also be treated with a silane coupling agent or the like in advance.

In the present invention, the composite particles may also be inorganic organic composite particles combined by bonding inorganic particles such as silica particles or alumina particles to the surfaces of organic particles composed of proper polymer particles. In this case, the inorganic particles may be bonded by being physically held by a bonding component such as siloxane on the surfaces of the polymer particles or be chemically bonded by a functional group such as a hydroxyl group existing on the surfaces of the polymer particles.

Those in a state that the inorganic organic composite particles obtained by the above-described integral bonding by electrostatic force have been modified by a modifying substance by a polycondensation reaction of, for example, an alkoxysilane, aluminum alkoxide, titanium alkoxide or the like in the presence of such inorganic organic composite particles can also be used as the composite particles.

When the composite particles are composed of the inorganic organic particles, such composite particles exist in any of the following States 1 to 3 according to the particle diameters and component proportions of the respective organic particles and inorganic particles forming the composite particles or exist in a condition that a plurality of states are mixed.
State 1: a state that the inorganic particles have adhered as shell particles to the surfaces of core particles composed of the organic particles.
State 2: a state that the organic particles have adhered as shell particles to the surfaces of core particles composed of the inorganic particles.
State 3: a state that the organic particle and inorganic particles have aggregated to each other without forming a clear core-shell structure.

Among the above-described states, State 1 or 2 is preferred.

In each of States 1 to 3, the inorganic particles may be in any state of primary particles and secondary particles, or both particles may be mixed.

With respect to the component proportions of the inorganic particle and organic particles forming the inorganic organic composite particles, the proportion of the inorganic particles is preferably 1 to 2,000 parts by weight, more preferably 10 to 1,000 parts by weight per 100 parts by weight of the organic particles.

In the present invention, the average particle diameter of the composite particles is preferably 20 to 20,000 nm, more preferably 50 to 10,000 nm, particularly preferably 50 to 5,000 nm.

By containing the composite particles satisfying the above-described conditions, there can be provided a polishing slurry which can achieve high removal rate, sufficiently prevents dishing and erosion and is high in stability.

In the polishing slurry according to the present invention, the proportion of the abrasive grains contained is such that the overall content of the simple particles (A) composed of at least one selected from the inorganic particles and organic particles and the composite particles (B) amounts to 0.11 to 20 % by mass based on 100 % by mass of the polishing slurry.

If the proportion of the abrasive grains contained is lower than 0.11 % by mass, the resulting polishing slurry cannot achieve any sufficient removal rate. If the proportion contained exceeds 20 % by mass on the other hand, the resulting polishing slurry becomes high in cost and may be deteriorated in shelf stability in some cases.

The content of the simple particles (A) composed of at least one selected from the inorganic particles and organic particles is preferably 0.1 to 19.99 % by mass, more preferably 0.1 to 10 % by mass, particularly preferably 0.5 to 10 % by mass based on 100 % by mass of the polishing slurry.

The content of the composite particles (B) is preferably 0.01 to 19.9 % by mass, more preferably 0.01 to 10 % by mass, particularly preferably 0.01 to 5 % by mass based on 100 % by mass of the polishing slurry.

A relative ratio of the simple particles (A) composed of at least one selected from the inorganic particles and organic particles to the composite particles (B) is preferably 1:10 to 10:1 by mass, more preferably 1:10 to 5:1, particularly preferably 1:5 to 5:1.

When the proportion of the abrasive grains contained falls within the above range, a polishing slurry which can prevent occurrence of surface defects such as scratches even for a surface to be polished, in which a fragile inter layer dielectrics exists, and achieves sufficient removal rate can be provided.

In the polishing slurry according to the present invention, a value of a ratio (RBM/RCu) (hereinafter also referred to as "specific removal rate ratio") of a removal rate (RBM) of a barrier metal film obtained by polishing the barrier metal film with this polishing slurry to a removal rate (RCu) of a copper film obtained by polishing the copper film under the same conditions as the case of the barrier metal film amounts to 0.5 to 200.

In the above, "copper film" includes films of copper alloys having a copper content of at least 95 % by mass, such as copper-silicon and copper-aluminum, in addition to films composed of pure copper.

"Barrier metal film" is formed by a metal having high hardness, such as tantalum or titanium, a nitride or oxide thereof, or the like. The metal forming the barrier metal film is not limited to a pure metal, and may be an alloy, for example, tantalum-niobium. When the barrier metal film is formed by a nitride, tantalum nitride, titanium nitride or the like is also not necessarily a pure substance. The material of this barrier metal film is particularly preferably tantalum and/or tantalum nitride.

The barrier metal film is often formed by only one material such as tantalum or titanium. However, films of different materials, for example, both tantalum film and tantalum nitride film may be formed on the same substrate as a barrier metal film in some cases.

"The same conditions" related to the specific removal rate ratio means that a polishing apparatus of a specified type is used, and the rotating speeds of the platen and head thereof, polishing pressure, polishing time, the kind of a polishing pad used, and the feeding rate of a polishing slurry per unit time are the same. The specific removal rate ratio can be calculated out from the values of respective removal rates of a copper film and a barrier metal film when both films are separately polished under "the same conditions". The polishing of these films can be conducted by using wafers equipped with the copper film and the barrier metal film, respectively.

In the polishing slurries according to the present invention, the specific removal rate ratio (RBM/RCu) can be optionally controlled within a range of 0.5 to 200. In order to control the specific removal rate ratio (RBM/RCu), the polishing slurries according to the present invention may contain a heterocyclic compound.

As examples of such a heterocyclic compound, may be mentioned quinolinecarboxylic acids, indolizines, compounds having a 5-membered heterocycle and compounds having a 6-membered heterocycle.

As examples of the quinolinecarboxylic acids, may be mentioned 2-quinolinecarboxylic acid (quinaldinic acid) and 2,3-pyridinedicarboxylic acid (quinolinic acid).

As examples of the indolizines, may be mentioned 7-hydroxy-5-methyl-1,3,4-triazaindolizine.

As examples of the compounds having a 5-membered heterocycle, may be mentioned benzotriazoles such as 1,2,3-benzotriazole, 1-(N,N-bis(2-ethylhexyl)aminomethyl)-benzotriazole, carboxybenzotriazole, 1-(2',3'-dihydroxypropyl)benzotriazole, 1-(2',3'-dicarboxyethyl)-benzotriazole and 1-(2-ethylhexylaminomethyl)benzotriazole; benzothiazoles such as 2-aminobenzothiazole, 2-amino-6-methylbenzothiazole and 2-mercaptobenzothiazole; triazoles such as 4-amino-1,2,4-triazole, 4-amino-3-hydrazino-5-mercapto-1,2,4-triazole, 3-mercapto-1,2,4-triazole and 3-mercapto-4-methyl-4H-1,2,4-triazole; tetrazoles such as 5-amino-1H-tetrazole, 1-phenyl-5-mercapto-1H-tetrazole, 1H-tetrazole, 1H-tetrazole-1-acetic acid and 1-(2-dimethylaminoethyl)-5-mercaptotetrazole; and 2-mercaptothiazoline, 4,5-dicyanoimidazole, 2-amino-4,5-dicyano-1H-imidazole and 3H-1,2,3-triazolo[4,5-b]pyridin-3-ol.

As examples of the compounds having a 6-membered heterocycle, may be mentioned triazines such as 3-amino-5,6-dimethyl-1,2,4-triazine, 2,4-diamino-6-diallylamino-1,3,5-triazine and 3-amino-5,6-dimethyl-1,2,4-triazine; and benzoguanamine, thiocyanuric acid, melamine, phthalazine and 2,3-dicyano-5-methylpyrazine.

As the heterocyclic compound, may also be used a derivative of a compound having both 5-membered heterocycle and 6-membered heterocycle. As such derivatives, may be mentioned adenine and guanine.

The content of such a heterocyclic compound may be controlled to 0.0001 to 5 % by mass, preferably 0.001 to 1 % by mass, more preferably 0.01 to 0.5 % by mass based on 100 % by mass of the polishing slurry. If the content of the heterocyclic compound is lower than 0.0001 % by mass, the removal rate of a copper film and/or a barrier metal film cannot be made sufficiently high. In particular, when such a polishing slurry is used in polishing of the barrier metal film, it takes a long time to polish this film. On the other hand, there is no need to contain this heterocyclic compound in an amount exceeding 5 % by mass.

As described above, the specific removal rate ratio (RBM/RCu) of the polishing slurries according to the present invention can be freely controlled within the range of 0.5 to 200.

The polishing slurries according to the present invention are thereby useful as aqueous dispersions for polishing in a second or third polishing treatment in the case where a chemical mechanical polishing step for a copper film in particular is conducted by the so-called 2-step polishing or 3-step polishing.

In the 2-step polishing, are conducted a first polishing treatment step that any other copper than copper filled in a wiring groove formed on a substrate is removed by polishing and a second polishing treatment step that a barrier metal film exposed by this first polishing treatment step is polished to form a wiring. In the 3-step polishing, after the 2-step polishing of above, a third polishing treatment step that a dielectrics exposed after the barrier metal film has been removed by polishing in the second polishing treatment step is polished is conducted as needed.

More specifically, the 2-step polishing is polishing process composed of 2 steps of a first polishing treatment step, in which a copper film is mainly polished, and a second polishing treatment step, in which a barrier metal film is mainly polished. The 2 polishing treatment steps may be performed independently of each other, and continuity with time and continuity related to a polishing apparatus between 2 steps are not required.

The first polishing treatment step and second polishing treatment step can be continuously conducted by successively changing and feeding a polishing slurry in the same polishing apparatus. In the same polishing apparatus, a semiconductor substrate that is an article to be polished may also be taken out after completion of the first polishing treatment step and perform the second polishing treatment step after changing the polishing slurry.

The first polishing treatment step and second polishing treatment step may also be conducted by separate polishing apparatus. A polishing apparatus having a plurality of polishing pads in its interior is used to conduct the first polishing treatment step by one polishing pad and the second polishing treatment step by the other polishing pad, whereby the first polishing treatment step and second polishing treatment step can also be continuously performed for an article to be polished.

Either of the first polishing treatment step and the second polishing treatment step can be achieved with operations divided into two or more.

In the first polishing treatment step in such a 2-step polishing treatment or 3-step polishing treatment as described above, for example, a polishing slurry whose specific removal rate ratio (RBM/RCu) is at most 0.1 may preferably be used.

As the aqueous dispersion for chemical mechanical polishing used in the first polishing treatment step, a polishing slurry containing abrasive grains, an oxidizing agent and an organic acid and containing a surfactant or the like as needed may be specifically used.

As the abrasive grains, may be used, for example, those composed of at least one of inorganic particles and organic particles. The proportion thereof is 0.01 to 10 % by mass, preferably 0.01 to 5 % by mass based on 100 % by mass of the polishing slurry.

As the oxidizing agent, may be used, for example, a persulfate (ammonium salt, potassium salt or the like), heteropoly-acid (for example, silicomolybdic acid, phosphomolybdic acid, silicotungstic acid, phosphotungstic acid or the like), permanganic acid compound (potassium salt or the like), bichromic acid compound (potassium salt or the like) or hydrogen peroxide. The proportion thereof is 0.01 to 10 % by mass, preferably 0.05 to 5 % by mass, particularly preferably 0.1 to 3 % by mass based on 100 % by mass of the polishing slurry.

As the organic acid, may be used, for example, one or at least two of quinolinic acid, quinolinecarboxylic acid, fumaric acid, phthalic acid, malic acid, tartaric acid and citric acid. The proportion thereof is 0.0001 to 7 % by mass, preferably 0.001 to 5 % by mass, more preferably 0.01 to 1 % by mass based on 100 % by mass of the polishing slurry.

The polishing slurry according to the present invention, whose specific removal rate ratio (RBM/RCu) is controlled to 10 to 200, preferably 15 to 200, more preferably 20 to 200, is particularly useful in the second polishing treatment step performed for a surface to be polished after polishing is conducted until the copper film is almost completely removed by the first polishing treatment step, since the removal rate of the barrier metal film is high, and the removal rate of the copper film is low when this polishing slurry is used.

As a heterocyclic compound used for providing the polishing slurry whose specific removal rate ratio (RBM/RCu) is 10 to 200, are preferred the benzotriazoles among the above-mentioned heterocyclic compounds. 1,2,3-Benzotriazole, carboxybenzotriazole, 1-(2',3'-dicarboxyethyl)benzotriazole and 1-(2-ethylhexyl-aminomethyl)benzotriazole are more preferred, with 1,2,3-benzotriazole being particularly preferred. The proportion contained is preferably 0.001 to 0.1 % by mass, more preferably 0.005 to 0.05 % by mass.

On the other hand, the polishing slurry according to the present invention, whose specific removal rate ratio (RBM/RCu) is controlled to 0.5 to 3, preferably 0.7 to 2, more preferably 0.8 to 1.5, is usefully used in the second polishing treatment step performed for an article to be polished that the polishing of the copper film is not complete in the first polishing treatment step, or the second or third polishing treatment step in the 3-step polishing treatment, since sufficient removal rate is achieved for both copper film and barrier metal film.

As a heterocyclic compound used for providing the polishing slurry whose specific removal rate ratio (RBM/RCu) is 0.5 to 3, are preferred the quinolinecarboxylic acids and indolizines among the above-mentioned heterocyclic compounds. Quinaldinic acid and quinolinic acid and 7-hydroxy-5-methyl-1,3,4-triazaindolizine are more preferred, with quinaldinic acid and 7-hydroxy-5-methyl-1,3,4-triazaindolizine being particularly preferred. The proportion contained is preferably 0.001 to 5 % by mass, more preferably 0.01 to 1 % by mass.

As described above, the polishing slurries according to the present invention contain (A) simple particles composed of at least one selected from inorganic particles and organic particles and (B) composite particles as abrasive grains and may contain a suitable heterocyclic compound for controlling the specific removal rate ratio (RBM/RCu). Further, the polishing slurries according to the present invention may contain additives such as an oxidizing agent, a surfactant and an organic acid as needed.

The oxidizing agent is added for the purpose of improving the removal rate. As the oxidizing agent, may be used, for example, a persulfate, hydrogen peroxide, inorganic acid, organic peroxide, polyvalent metal salt or the like.

As examples of the persulfate, may be mentioned ammonium persulfate and potassium persulfate. As examples of the inorganic acid, may be mentioned nitric acid and sulfuric acid. As examples of the organic peroxide, may be mentioned peracetic acid, perbenzoic acid and tert-butyl hydroperoxide.

As examples of the polyvalent metal salt, may be mentioned permanganic acid compound and bichromic acid compounds. The permanganic acid compound may include potassium permanganate, and the bichromic acid compounds may include potassium bichromate.

Among these, hydrogen peroxide, persulfates and inorganic acids are preferred as the oxidizing agent.

The proportion of the oxidizing agent contained may be controlled to at most 10 % by mass, preferably 0.01 to 10 % by mass, particularly 0.05 to 5 % by mass, especially 0.1 to 3 % by mass based on 100 % by mass of the polishing slurry. It is not necessary to contain the oxidizing agent in a proportion exceeding 10 % by mass.

The surfactant is added for the purpose of controlling the removal rate and reducing scratches, and any of a cationic surfactant, an anionic surfactant and a nonionic surfactant may be used. The anionic surfactant is particularly preferred.

As examples of such an anionic surfactant, may be mentioned carboxylic acid salts, sulfonic acid salts, sulfate salts and phosphate salts.

As examples of the carboxylic acid salts, may be mentioned fatty acid soap and alkyl ether carboxylic acid salts. As examples of the sulfonic acid salts, may be mentioned alkyl benzene sulfonic acid salts, alkyl naphthalene sulfonic acid salts and α-olefinsulfonic acid salts. As examples of the sulfate salts, may be mentioned higher alcohol sulfate salts, alkyl ether sulfate salts and polyoxyethylene alkyl phenyl ether sulfate salts. As examples of the phosphate salts, may be mentioned alkyl phosphate salts.

Among these anionic surfactants, sulfonic acid salts are preferred, alkyl benzene sulfonic acid salts are more preferred, with potassium dodecylbenzenesulfonate being particularly preferred.

The proportion of the surfactant contained may preferably be controlled to at most 5 % by mass, more preferably at most 1 % by mass, particularly preferably at most 0.5 % by mass based on the 100 % by mass of the polishing slurry. If this content exceeds 5 % by mass, the removal rate of the copper film in particular is greatly decreased. It is hence not preferable to contain the surfactant in such a high proportion.

In the present invention, the organic acid is added for the purpose of improving the removal rate. For this purpose, wide kinds of organic acid, such as monobasic acids, dibasic acids, hydroxy acids and carboxylate acids, may be used. For example, saturated acids, unsaturated acids and aromatic acids may be mentioned.

As examples of the saturated acids, may be mentioned formic acid, acetic acid, butyric acid, oxalic acid, malonic acid, succinic acid, glutaric acid, adipic acid and hydroxy acids. As examples of the unsaturated acid, may be mentioned maleic acid and fumaric acid. As examples of the aromatic acids, may be mentioned benzoic acid and phthalic acid. As examples of the hydroxy acids, may be mentioned lactic acid, malic acid, tartaric acid and citric acid.

Among these organic acids, malonic acid, succinic acid, maleic acid, lactic acid and citric acid are preferred.

The proportion of the organic acid contained may be controlled to at most 10 % by mass, preferably 0.01 to 10 % by mass, particularly 0.1 to 5 % by mass, especially 0.3 to 3 % by mass based on 100 % by mass of the polishing slurry. It is not necessary to contain the organic acid in a proportion exceeding 5 % by mass.

The polishing slurries according to the present invention are obtained by dispersing or dissolving the abrasive grains, heterocyclic compound and additives described above in an aqueous medium. As the aqueous medium, may be mentioned water, mixed medium of water and alcohol, and the like. As examples of the alcohol, may be mentioned methanol and ethanol. Among these media, water is preferred as the aqueous medium.

The pH of the polishing slurries according to the present invention may be controlled to a value of a suitable region within a range of 2 to 12, with pH 3 to 11 being particularly preferred. When the pH falls within this range, sufficient removal rate can be realized, and occurrence of surface defects such as scratches can be prevented even when a fragile dielectrics is polished.

The pH of the polishing slurry whose specific removal rate ratio (RBM/RCu) is controlled to 10 to 200 is preferably 7 to 12, more preferably 8 to 11 when the polishing slurry is used in the second polishing treatment step performed for an article to be polished that the copper film has been almost completely removed in the first polishing treatment step of the 2-step polishing treatment. When the pH falls within this range, the removal rate of the barrier metal film becomes sufficient, and occurrence of surface defects such as scratches can be prevented even when a fragile dielectrics is polished.

The pH of the polishing slurry whose specific removal rate ratio (RBM/RCu) is controlled to 0.5 to 3 is preferably 5 to 10, more preferably 6 to 9 when the polishing slurry is used in the second polishing treatment step performed for an article to be polished that the copper film is not completely removed in the first polishing treatment step of the 2-step polishing treatment, or used in the second or third polishing treatment step of the 3-step polishing treatment. When the pH falls within this range, both removal rates of the barrier metal film and copper film becomes sufficient, and occurrence of surface defects such as scratches can be prevented even when a fragile dielectrics is polished.

The adjustment of the pH can be conducted by means that a proper amount of the inorganic acid or organic acid described above is added, and also by means that a suitable basic substance is contained in a proper amount.

As examples of the basic substance, may be mentioned hydroxides of alkali metals and ammonia. As the hydroxide of an alkali metal, may be used sodium hydroxide, potassium hydroxide, rubidium hydroxide or cesium hydroxide.

In order to perform a chemical mechanical polishing treatment of a semiconductor substrate or the like with the polishing slurry according to the present invention, it is only necessary to use a commercially available chemical mechanical polishing apparatus, for example, "EPO-112" or "EPO-222" manufactured by Ebara Corporation, "LGP-510" or Model "LGP-552" manufactured by Lap Master SFT Corp., "Mirra" manufactured by Applied Materials Inc., or the like to conduct the polishing treatment under prescribed conditions.

After completion of the polishing treatment, the abrasive grains remaining on the polished surface are preferably removed. The removal of the abrasive grains can be conducted by an ordinary cleaning method. For example, cleaning is conducted with an alkaline washing solution containing ammonia, hydrogen peroxide and water in a ratio of about 1:1:5 in terms of weight after brush-scrubbing, whereby the abrasive grains adhered to the surface to be polished can be removed.

In order to remove impurity metal species adsorbed on the polished surface, cleaning may be conducted with a cleaning solution composed of, for example, an aqueous solution of citric acid, a mixed aqueous solution of hydrofluoric acid and citric acid or a mixed aqueous solution of hydrofluoric acid and ethylenediaminetetraacetic acid (EDTA).

The polished surface may also be heated to a high temperature in the presence of oxygen, thereby burning and removing the organic particles on the polished surface. As examples of a specific method of burning, may be mentioned an ashing treatment by causing oxygen plasma to act or with plasma by supplying oxygen radical by down flow. By this method, the organic particles remaining on the polished surface can be easily removed.

According to the present invention, a semiconductor substrate provided with a copper film and a barrier metal film and also with an inter layer dielectrics of, for example, a low dielectric constant is provided as an article to be polished, and chemical mechanical polishing is performed for the intended surface thereof to be polished with the aqueous dispersion for chemical mechanical polishing, thereby producing a semiconductor device is produced.

A copper film in the semiconductor substrate, which is an article to be polished, is not limited to that composed of pure copper and may be a film composed of a copper alloy having a copper content of at least 95 % by mass, such as copper-silicon or copper-aluminum.

A barrier metal film is formed by a metal having high hardness, such as tantalum or titanium, a nitride or oxide thereof, or the like. The metal forming the barrier metal film is not limited to a pure metal, and may be an alloy, for example, tantalum-niobium. When the barrier metal film is formed by a nitride, tantalum nitride, titanium nitride or the like is also not necessarily a pure substance. The material of this barrier metal film is particularly preferably tantalum and/or tantalum nitride.

The barrier metal film is often formed by only one material selected from tantalum or titanium and the like. However, films of different materials, for example, both tantalum film and tantalum nitride film may be formed on the same substrate as a barrier metal film.

As examples of the inter layer dielectrics, may be mentioned a SiO₂ film, a boro phospho silicate film (BPSG film) in which a small amount of boron and phosphorus is added to SiO₂, a dielectrics called FSG (fluorine-doped silicate glass) in which fluorine is doped in SiO₂ and a silicon oxide dielectrics of low dielectric constant.

As examples of silicon oxide, may be mentioned a thermal oxide film, a PETEOS film (plasma enhanced-TEOS film), an HDP film (high density plasma enhanced-TEOS film) and a silicon oxide film obtained by a thermal CVD process.

The thermal oxide film can be formed by exposing silicon heated to a high temperature to an oxidative atmosphere to chemically react the silicon with oxygen or water. The PETEOS film can be formed by a chemical vapor phase epitaxy process using tetraethyl orthosilicate (TEOS) as a raw material and utilizing plasma as accelerating conditions. The HDP film can be formed by a chemical vapor phase epitaxy process using tetraethyl orthosilicate (TEOS) as a raw material and utilizing high density plasma as accelerating conditions.

The silicon oxide film obtained by the thermal CVD process can be obtained by an atmospheric pressure CVD process (AP-CVD process) or low pressure CVD process (LP-CVD process). The boro phospho silicate film (BPSG film) can be obtained by the atmospheric pressure CVD process (AP-CVD process) or low pressure CVD process (LP-CVD process). The dielectrics called FSG (fluorine-doped silicate glass) can be formed by a chemical vapor phase epitaxy process utilizing high density plasma as accelerating conditions.

The silicon oxide dielectrics of low dielectric constant can be obtained by applying a raw material on to a substrate by, for example, a spin coating method and then heating it under an oxidative atmosphere. As examples of the silicon oxide dielectrics of low dielectric constant obtained in such a manner, may be mentioned an HSQ film (hydrogen silsesquioxane film) using triethoxysilane as a raw material, an MSQ film (methyl silsesquioxane film) using tetraethoxysilane and a small amount of methyltrimethoxysilane as raw materials, and dielectrics of low dielectric constant using other silane compounds as raw materials. As these dielectrics of low dielectric constant, dielectrics obtained by mixing proper organic polymer particles with the raw material and using the mixture, thereby burning out the polymer to form voids in a heating step to make the dielectric constant lower may also be used. Dielectrics of a low dielectric constant using an organic polymer such as polyarylene polymer, polyallylene ether polymer, polyimide polymer or benzocyclobutene polymer as a raw material may also be mentioned.

### [Examples]

The present invention will hereinafter be described in more detail by the following Examples. All designations of "part" or "parts" as will be used in the following examples mean part or parts by mass unless expressly noted.

### (1) Preparation of Aqueous Dispersion DA1 containing inorganic particles:

### (1-1) Preparation of Aqueous Dispersion DA1 containing Fumed Silica Particles A1:

Fumed silica particles (product of Nippon Aerosil Co., Ltd.; trade name "Aerosil #90"; average primary particle diameter: 20 nm) in an amount of 2 kg were dispersed in 6.7 kg of ion-exchanged water by means of an ultrasonic dispersing machine, and the dispersion was filtered through a filter having a pore size of 5 µm to prepare Aqueous Dispersion DA1 containing Fumed Silica Particles A1 The average secondary particle diameter of the silica particles in Aqueous Dispersion DA1 was 220 nm. (1-2) Preparation of Aqueous Dispersion DA2 containing

### Colloidal Silica Particles A2:

A rotating type dispersing machine was charged with 70 parts of aqueous ammonia having a concentration of 25 % by mass, 40 parts of ion-exchanged water, 35 parts of ethanol and 15 parts of tetraethoxysilane, and the mixture was heated to 60°C with stirring at 180 rpm. After the mixture was continuously stirred for 2 hours at this temperature, it was cooled to obtain an alcohol dispersion of colloidal silica particles. A process of removing an alcohol component by means of an evaporator while adding ion-exchanged water at 80°C was repeated several times to remove the alcohol component in the dispersion, thereby preparing Aqueous Dispersion DA2 containing Colloidal Silica Particles A2 at a solid concentration of 8 % by mass. The average primary particle diameter of Colloidal Silica Particles A2 in Aqueous Dispersion DA2 was 30 nm, while the average secondary particle diameter was 45 nm.

### (2) Preparation of aqueous dispersion containing Composite Particles B:

### (2-1) Preparation of Aqueous Dispersion Db1 containing organic particles:

A flask was charged with 90 parts of methyl methacrylate, 5 parts of methoxypolyethylene glycol methacrylate (product of Shin-Nakamura Chemical Co., Ltd.; trade name "NK Ester M-90G", #400), 5 parts of 4-vinylpyridine, 2 parts of an azo type polymerization initiator (product of Wako Pure Chemicals Industries, Ltd.; trade name "V50") and 400 parts of ion-exchanged water, and the mixture was heated to 70°C with stirring under a nitrogen gas atmosphere to conduct polymerization for 6 hours, thereby obtaining an aqueous dispersion containing organic particles having an average particle diameter of 150 nm composed of a polymethyl methacrylate polymer having a cation of an amino group and a polyethylene glycol chain as functional groups. This aqueous dispersion was diluted with water, thereby obtaining an aqueous dispersion the organic particle content in which was adjusted to 10 % by mass. The yield of the polymerization was 95%.

A flask was charged with 100 parts of the thus-obtained aqueous dispersion containing the organic particles in a proportion of 10 % by mass and, 1 part of methyltrimethoxysilane was added, the mixture was stirred at 40°C for 2 hours, and nitric acid was then added to adjust the pH thereof to 2, thereby obtaining Aqueous Dispersion Db1. The zeta potential of the organic particles contained in Aqueous Dispersion Db1 was +17 mV.

### (2-2) Preparation of Aqueous Dispersion Db2 containing inorganic particles:

Colloidal silica dispersion (product of Nissan Chemical Industries, Ltd.; trade name "Snowtex O", average primary particle diameter: 12 nm) was dispersed in water, and an aqueous solution of potassium hydroxide was added to the dispersion to adjust a pH of the dispersion, thereby obtaining Aqueous Dispersion Db2 having a pH of 8 and containing 10 % by mass of inorganic particles composed of colloidal silica. The zeta potential of the silica particles contained in Aqueous Dispersion Db2 was -40 mV.

### (2-3) Preparation of Composite Particles B:

While stirring 100 parts of Aqueous Dispersion Db1, 50 parts of Aqueous Dispersion Db2 were gradually added thereto over 2 hours, and the resultant mixture was additionally stirred for 2 hours to obtain Aqueous Dispersion Db containing Composite Particles B with the inorganic particles composed of silica bonded to the surfaces of the organic particles composed of the polymethyl methacrylate polymer. To Aqueous Dispersion Db, were added 2 parts of vinyltriethoxysilane, and the mixture was stirred for 1 hour. Thereafter, 1 part of tetraethoxysilane was added, and the mixture was heated to 60°C, continuously stirred for 3 hours and then cooled, thereby obtaining Aqueous Dispersion DB containing Composite Particle B having an average particle diameter of 180 nm in a proportion of 10 % by mass. Composite Particles B were such that the silica particles adhered to the outer surfaces of the polymethyl methacrylate polymer particles so as to cover 80% of the surface area thereof.

### (3) Production of dielectrics of low dielectric constant:

### (3-1) Preparation of polysiloxane sol:

A mixed solution composed of 101.5 g of methyltrimethoxysilane, 276.8 g of methyl methoxypropionate and 9.7 g of tetraisopropoxytitanium/ethyl acetoacetate complex was heated to 60°C, and a mixture of 92.2 g of γ-butyrolactone and 20.1 g of water was added dropwise to this mixed solution over 1 hour. After completion of the addition, a reaction was conducted at 60°C for 1 hour to obtain polysiloxane sol.

### (3-2) Production of polystyrene particles:

A flask was charged with 100 parts of styrene, 2 parts of an azo type polymerization initiator (product of Wako Pure Chemicals Industries, Ltd.; trade name "V60"), 0.5 parts of potassium dodecylbenzenesulfonate and 400 parts of ion-exchanged water, and the mixture was heated to 70°C under the nitrogen atmosphere with stirring to conduct polymerization for 6 hours, thereby obtaining polystyrene particles having an average particle diameter of 150 nm.

### (3-3) Production of dielectrics of low dielectric constant:

Fifteen grams of the polysiloxane sol obtained in the step (3-1) were mixed with 1 g of the polystyrene particles obtained in the step (3-2), and the resultant mixture was coated on to a thermal oxide film-coated silicon substrate having a diameter of 0.2m (8 inch) by a spin coating method to form a coating film. Thereafter, the substrate was heated at 80°C for 5 minutes and then at 200°C for 5 minutes in an oven. The substrate was then heated at 340°C for 30 minutes, at 360°C for 30 minutes, at 380°C for 30 minutes and additionally at 450°C for 1 hour under reduced pressure, thereby forming a colorless transparent film having a thickness of 2,000 Å (1Å = 0.1nm).

The section of this film was observed through a scanning electron microscope. As a result, it was confirmed that a great number of fine voids are formed. The relative dielectric constant, modulus of elasticity and voids thereof were 1.98, 3 GPa and 15%, respectively.

### Example 1:

### [Preparation of polishing slurry]

A polyethylene-made bottle was charged 2 parts by mass, in terms of solids, of Aqueous Dispersion A1 containing the fumed silica particles prepared in the step (1-1) and 0.5 parts by mass, in terms of solids, of Aqueous Dispersion B containing the composite particles prepared in the step (2), 0.02 parts by mass of 1,2,3-benzotriazole (BTA), 1 part by mass of maleic acid, 0.05 parts by mass of potassium dodecylbenzenesulfonate (PDBS) and 1 part by mass of hydrogen peroxide were successively contained, and the resultant mixture was stirred for 15 minutes. The pH of the mixture was adjusted to 9 with potassium hydroxide, ion-exchanged water was added in such a manner that the total mass of all the components is 100 parts by mass, and the thus-adjusted mixture was filtered through a filter having a pore size of 5 µm to obtain a polishing slurry having a pH of 9.5. This slurry is called "Slurry 1".

### [Evaluation of removal rate]

Slurry 1 prepared above was used, and a wafer having various kinds of films was placed on a chemical mechanical polishing apparatus (CMP apparatus, Model "EPO112", manufactured by Ebara Corporation) to perform polishing for 1 minute by means of a polishing pad (product of Rodel Nitta, Ltd.; trade name "IC1000") made of porous polyurethane under the following conditions to evaluate a removal rate.
Head rotating speed: 70 rpm
Head load: 250 g/cm²
Table rotating speed: 70 rpm
Polishing slurry-feeding rate: 300 ml/min
Articles to be polished for evaluation are the following wafers.

### (1) Wafer Sample 1 for evaluating removal rate on copper film:

A wafer obtained by forming a copper film having a thickness of 15,000 Å on a silicon substrate 8-inch in diameter having a thermal oxide film.

### (2) Wafer Sample 2 for evaluating removal rate on barrier metal film:

A wafer obtained by forming a tantalum nitride film having a thickness of 1,500 Å on a silicon substrate 0.2m (8-inch) in diameter having a thermal oxide film.

### (3) Wafer Sample 3 for evaluating removal rate on dielectrics:

A wafer obtained by forming a plasma TEOS film having a thickness of 10,000 Å on a silicon substrate 8-inch in diameter.

### (4) Wafer Sample 4 for evaluating removal rate on dielectrics of low dielectric constant:

The thermal oxide film-coated silicon substrate 8 inch in diameter produced in the step (3-3), on which a dielectrics of law dielectric constant having a thickness of 2,000 Å was formed.

The film thickness after the polishing treatment was measured in accordance with the following method to calculate out the removal rate. The results are shown in Table 1. More specifically, the thickness of the copper film and tantalum nitride film were measured by means of an electroconduction type film thickness meter (manufactured by KLA-Tencor Co., model "OMNIMAP RS75"). The thickness of the TEOS film and dielectrics of low dielectric constant were measured by means of a light interference type film meter (manufacture by SENTEC Co., model "FPT500").

### [Evaluation]

Peeling of an outer peripheral portion of the dielectrics of low dielectric constant and the number of scratches after the polishing treatment were evaluated. More specifically, after a dielectrics of low dielectric constant was formed on a silicon substrate in the same manner as in the step (3-3), and this substrate was polished under the same conditions as described above, it was cleaned and dried, and separation at the outer peripheral portion was then observed visually and through an optical microscope.

The whole surface of the polished surface was observed visually, through an optical microscope and by a pattern-free wafer surface dust particle inspection apparatus (manufactured by KLA-Tencor Co., model "Surfscann SP1") to evaluate the number of scratches.

The results are shown in Table 1.

### Examples 2 to 5, and Comparative Examples 1 and 2:

Six polishing slurries "Slurry 2" to "Slurry 7" were evaluated as to polishing performance in the same manner as in Example 1 except that the polishing slurries were prepared by changing the abrasive grains, other additives and pH in accordance with their corresponding formulations shown in Table 1, and used respectively. The results are shown in Table 1.

In Table 1, "BTA" in the line of Heterocyclic compound means 1,2,3-benzotriazole, and "HMT" means 7-hydroxy-5-methyl-1,3,4-triazaindolizine. "PDBS" in the line of Surfactant means potassium dodecylbenzenesulfonate.

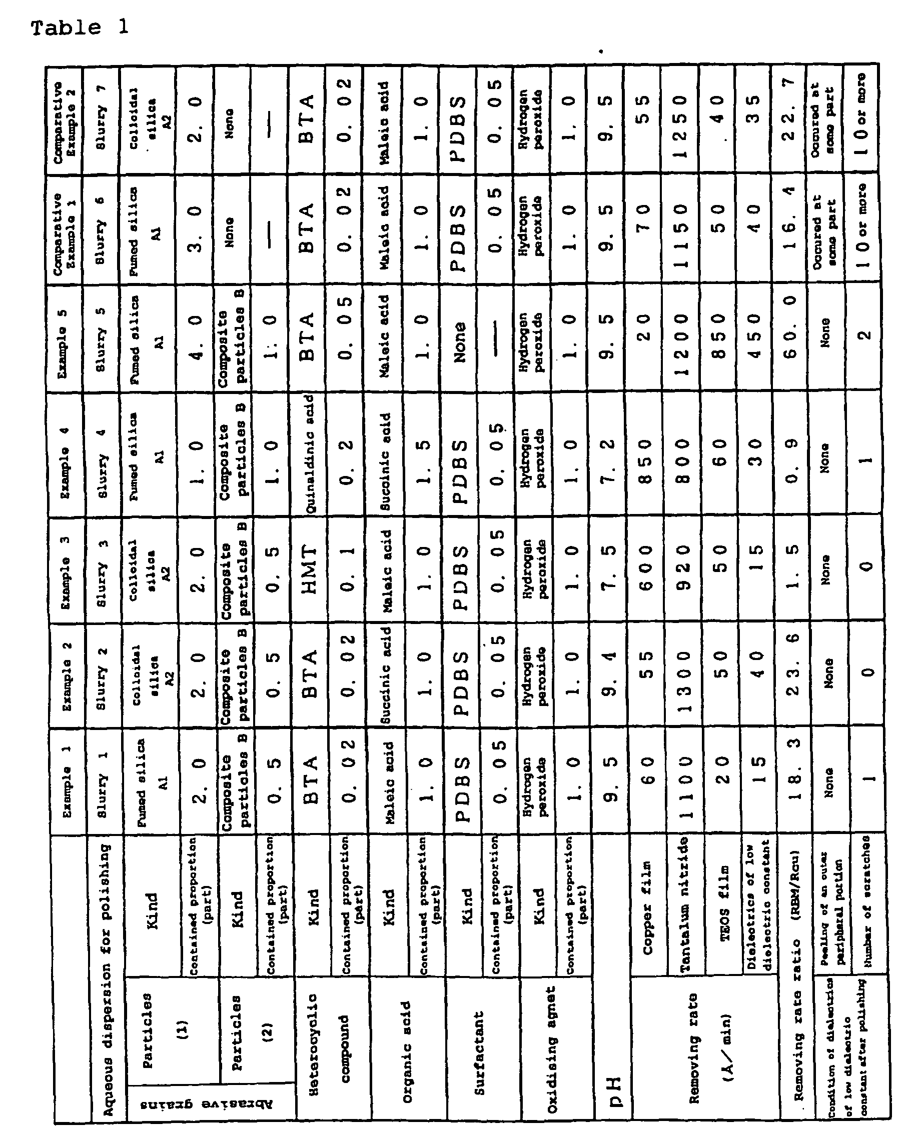

It is understood from the results shown in Table 1 that according to the polishing slurries of Comparative Examples 1 and 2 containing only the inorganic particles as the abrasive grains, the number of scratches on the surface of the dielectrics of low dielectric constant is increased, and peeling partially occurs though the removal rate of the barrier metal film is high.

On the other hand, it is understood that according to the polishing slurries of Examples 1 to 5 containing both composite particles and inorganic particles, sufficiently high removal rate as to the barrier metal film is achieved, the removal rate ratio of the copper film to the barrier metal can be optionally controlled by changing the kind and amount of the heterocyclic compound added, and scratches on the surface of the dielectrics of low dielectric constant are not caused at all or extremely little.

### Examples 6 to 10:

In these examples, a 2-step polishing treatment was performed.

### [Preparation of polishing slurry]

### (1) Preparation of Slurry 8.

A polishing slurry (Slurry 8) containing 1 part of fumed silica, 1 part of quinolinic acid, 0.7 parts of oxalic acid, 0.05 parts of potassium dodecylbenzene-sulfonate and 1 part of hydrogen peroxide per 100 parts of the polishing slurry and adjusted to pH 9 with potassium hydroxide was prepared in a similar manner to Example 1.

### (2) Preparation of Slurry 9.

A polishing slurry (Slurry 9) containing 1 part of fumed silica, 0.5 parts of quinaldinic acid, 0.05 parts of potassium dodecylbenzene-sulfonate and 1 part of ammonium persulfate per 100 parts of the polishing slurry and adjusted to pH 9.5 with potassium hydroxide was prepared in a similar manner to Example 1.

A patterned substrate (831CMP001 substrate, product of International SEMATECH) was used as a sample for evaluation, and this substrate was subjected to a polishing treatment under the following conditions to measure the sizes of dishing at a copper wiring portion of a line width of 100 µm and erosion at an alternate wiring site, in which a copper wiring 4.5 µm wide and a dielectrics portion 0.5 µm wide are alternately formed, by means of a probe type step height meter (HRP240 manufactured by KLA-Tencor Co.)

### [Polishing treatment]

### (1) First polishing treatment step:

The same polishing apparatus and polishing pad as those used in Example 1 were used. In a treatment using Slurry 8, the polishing treatment was performed under the conditions that head rotating speed of 100 rpm, head load of 105 g/cm², table rotating speed of 100 rpm, polishing slurry-feeding rate of 300 ml/min, and polishing time of 192 seconds.
Dishing at the copper wiring portion of a line width of 100 µm was 750 Å, and erosion at the alternate wiring site was 380 Å.

In a treatment using Slurry 9, the polishing treatment was performed under the conditions, that head rotating speed of 100 rpm, head load of 250 g/cm², table rotating speed of 100 rpm, polishing slurry-feeding rate of 300 ml/min and polishing time of 165 seconds. Dishing at the copper wiring portion of a line width of 100 µm was 300 Å, and erosion at the alternate wiring site was 390 Å.

### (2) Second polishing treatment step:

The same polishing apparatus and polishing pad as those used in Example 1 were used. Slurry 1 to Slurry 5 were respectively used to conduct the polishing treatment under the conditions that head rotating speed of 70 rpm, head load of 250 g/cm², table rotating speed of 70 rpm, polishing slurry-feeding rate of 300 ml/min and polishing time of 45 or 60 seconds.

The results are shown in Table 2.

**Table 2**

| | | Example 6 | Example 7 | Example 8 | Example 9 | Example 10 |
|---|---|---|---|---|---|---|
| First polishing treatment step | Slurry | Slurry 8 | Slurry 8 | Slurry 9 | Slurry 9 | Slurry 9 |
| | polishing time (sec) | 192 | 192 | 165 | 165 | 165 |
| Second polishing treatment step | Slurry | Slurry 1 | Slurry 2 | Slurry 3 | Slurry 4 | Slurry 5 |
| | Polishing time (see) | 45 | 45 | 60 | 60 | 60 |
| Dishing (Å) | | 450 | 480 | 205 | 200 | 280 |
| Erosion (Å) | | 200 | 210 | 250 | 215 | 190 |

### [Effects of the invention]

According to the aqueous dispersions used for chemical mechanical polishing of the present invention, occurence of scratches in a poliched surface is greatly prevented even when it is used in a polishing treatment of an article to be polished composed of a semiconductor substrate having an inter layer dielectrics low in mechanical strength and dielectric constant, a ratio of the removal rate of a copper film to the removal rate of a barrier metal film can be easily controlled with a great degree of freedom to polish both copper film and barrier metal film with high efficiency, and a sufficiently planarized finished surface with high precision can be provided without overpolishing the dielectrics.

According to the production process of a semiconductor device of the present invention, occurrence of scratches in a polished surface in a polishing treatment is greatly prevented even in a semiconductor substrate having an inter layer dielectrics low in mechanical strength and dielectric constant, both copper film and barrier metal film can be polished with high efficiency, and a sufficiently planarized finished surface with high precision can be provided without overpolishing the dielectrics.

The invention provides the use of an aqueous dispersion for chemical mechanical polishing, by which scratches are reduced even for an article to be polished having a dielectrics low in mechanical strength, both copper film and barrier metal film can be polished with high efficiency, and a sufficiently planarized finished surface with high precision can be provided without overpolishing the dielectrics, and a production process of a semiconductor device.

The aqueous dispersion used for chemical mechanical polishing comprises abrasive grains, wherein the abrasive grains include (A) simple particles composed of inorganic particles and (B) composite particles It is preferred that the simple particles (A) are composed of inorganic particles and composite particles (B) are composed of inorganic organic composite particles that formed of organic particles and inorganic particles combined integraly. The production process of a semiconductor device comprises the step of polishing a surface to be polished of a semiconductor material with the aqueous dispersion for polishing.

## Claims

1. Use of an aqueous dispersion for chemical mechanical polishing comprising abrasive grains, wherein the abrasive grains include:
(A) simple inorganic particles and
(B) composite particles obtained by integrally combining organic particles with inorganic particles,
for polishing a barrier metal film in chemical mechanical polishing.

2. The use according to claim 1, wherein the simple inorganic particles (A) are particles of either one of fumed silica and colloidal silica.

3. The use according to claim 1 or 2, wherein the overall content of all the abrasive grains is 0.11 to 20 % by mass, the content of the simple particles (A) is 0.1 to 19.99 % by mass, and the content of the composite particles (B) is 0.01 to 19.9 % by mass.

4. The use according to any one of claims 1 to 3, wherein the value of the specific removal rate ratio (RBM/RCu) represented by the ratio of the removal rate (RBM) of a barrier metal film to the removal rate (RCu) of a copper film in the case where the copper film and barrier metal film are polished under the same conditions is 0.5 to 200.

5. The use according to any one of claims 1 to 3, wherein the value of the specific removal rate ratio (RBM/RCu) represented by the ratio of the removal rate (RBM) of a barrier metal film to the removal rate (RCu) of a copper film in the case where the copper film and barrier metal film are polished under the same conditions is 10 to 200.

6. The use according to any one of claims 1 to 3, wherein the value of the specific removal rate ratio (RBM/RCu) represented by the ratio of the removal rate (RBM) of a barrier metal film to the removal rate (RCu) of a copper film in the case where the copper film and barrier metal film are polished under the same conditions is 0.5 to 3.

7. A process for producing a semiconductor device, comprising a step of polishing a surface to be polished of a semiconductor material including a barrier metal film with the aqueous dispersion for chemical mechanical polishing as defined in any one of claims 1 to 6 to mainly polish said barrier metal film.

8. The process according to claim 7, comprising a first polishing treatment step of mainly polishing a copper film of a surface to be polished of a semiconductor material and a second polishing treatment step of mainly polishing a barrier metal film with the aqueous dispersion for chemical mechanical polishing as defined in claim 5 or 6, conducted after the first polishing treatment step.

## Patentansprüche

1. Verwendung einer Schleifkörner umfassenden wässrigen Dispersion für chemisch mechanisches Polieren, wobei die Schleifkörner beinhalten:
(A) einfache anorganische Teilchen und
(B) Kompositteilchen, erhalten durch integrales Kombinieren organischer Teilchen mit anorganischen Teilchen,
zum Polieren eines Barrieremetallfilms bei chemisch mechanischem Polieren.

2. Verwendung nach Anspruch 1, wobei die einfachen anorganischen Teilchen (A) Teilchen aus einem aus Quarzstaub und kolloidalem Siliziumoxid sind.

3. Verwendung nach Anspruch 1 oder 2, wobei der Gesamtgehalt aller Schleifkörner 0,11 bis 20 Massen-% ist, der Gehalt der einfachen Teilchen (A) 0,1 bis 19,99 Massen-% ist, und der Gehalt der Kompositteilchen (B) 0,01 bis 19,9 Massen-% ist.

4. Verwendung nach einem der Ansprüche 1 bis 3, wobei der Wert des spezifischen Abtragratenverhältnisses (RBM/RCu), dargestellt durch das Verhältnis der Abtragrate (RBM) eines Barrieremetallfilm zu der Abtragrate (RCu) eines Kupferfilms in dem Fall, wo der Kupferfilm und der Barrieremetallfilm unter den gleichen Bedingungen poliert werden, 0,5 bis 200 ist.

5. Verwendung nach einem der Ansprüche 1 bis 3, wobei der Wert des spezifischen Abtragratenverhältnisses (RBM/RCu), dargestellt durch das Verhältnis der Abtragrate (RBM) eines Barrieremetallfilm zu der Abtragrate (RCu) eines Kupferfilms in dem Fall, wo der Kupferfilm und der Barrieremetallfilm unter den gleichen Bedingungen poliert werden, 10 bis 200 ist.

6. Verwendung nach einem der Ansprüche 1 bis 3, wobei der Wert des spezifischen Abtragratenverhältnisses (RBM/RCu), dargestellt durch das Verhältnis der Abtragrate (RBM) eines Barrieremetallfilm zu der Abtragrate (RCu) eines Kupferfilms in dem Fall, wo der Kupferfilm und der Barrieremetallfilm unter den gleichen Bedingungen poliert werden, 0,5 bis 3 ist.

7. Verfahren zur Herstellung einer Halbleitervorrichtung, umfassend den Schritt des Polierens einer zu polierenden Oberfläche eines einen Barrieremetallfilm enthaltenden Halbleitermaterials mit der wie in einem der Ansprüche 1 bis 6 definierten wässrigen Dispersion für chemisch mechanisches Polieren, um hauptsächlich den Barrieremetallfilm zu polieren.

8. Verfahren nach Anspruch 7, umfassend einen ersten Polierbehandlungsschritt des Polierens hauptsächlich eines Kupferfilms einer zu polierenden Oberfläche eines Halbleitermaterials und einen zweiten Polierbehandlungsschritt des Polierens hauptsächlich eines Barrieremetallfilms mit der wie in Anspruch 5 oder 6 definierten wässrigen Dispersion für chemisch mechanisches Polieren, durchgeführt nach dem ersten Polierbehandlungsschritt.

## Revendications

1. Utilisation d'une dispersion aqueuse pour polissage chimio-mécanique comprenant des grains abrasifs, dans laquelle les grains abrasifs incluent :
(A) des particules inorganiques simples et
(B) des particules composites obtenues en combinant intégralement des particules organiques avec des particules inorganiques, pour polir un film métallique barrière dans un polissage chimio-mécanique.

2. Utilisation selon la revendication 1, dans laquelle les particules inorganiques simples (A) sont des particules de l'une ou l'autre de silice fumée et de silice colloïdale.

3. Utilisation selon la revendication 1 ou 2, dans laquelle la teneur globale de tous les grains abrasifs est 0,11 à 20% en masse, la teneur des particules simples (A) est 0,1 à 19,99% en masse, et la teneur des particules composites (B) est 0,01 à 19,9% en masse.

4. Utilisation selon l'une quelconque des revendications 1 à 3, dans laquelle la valeur du rapport de taux d'enlèvement spécifique (RBM/RCu) représenté par le rapport du taux d'enlèvement (RBM) d'un film métallique barrière sur le taux d'enlèvement (RCu) d'un film de cuivre dans le cas où le film de cuivre et le film métallique barrière sont polis sous les mêmes conditions est 0,5 à 200.

5. Utilisation selon l'une quelconque des revendications 1 à 3, dans laquelle la valeur du rapport de taux d'enlèvement spécifique (RBM/RCu) représenté par le rapport du taux d'enlèvement (RBM) d'un film métallique barrière sur le taux d'enlèvement (RCu) d'un film de cuivre dans le cas où le film de cuivre et le film métallique barrière sont polis sous les mêmes conditions est 10 à 200.

6. Utilisation selon l'une quelconque des revendications 1 à 3, dans laquelle la valeur du rapport de taux d'enlèvement spécifique (RBM/RCu) représenté par le rapport du taux d'enlèvement (RBM) d'un film métallique barrière sur le taux d'enlèvement (RCu) d'un film de cuivre dans le cas où le film de cuivre et le film métallique barrière sont polis sous les mêmes conditions est 0,5 à 3.

7. Procédé de production d'un dispositif semi-conducteur, comprenant une étape de polissage d'une surface destinée à être polie d'un matériau semi-conducteur incluant un film métallique barrière avec la dispersion aqueuse pour polissage chimio-mécanique selon l'une quelconque des revendications 1 à 6 pour polir principalement ledit film métallique barrière.

8. Procédé selon la revendication 7, comprenant une première étape de traitement par polissage consistant à polir essentiellement un film de cuivre d'une surface destinée à être polie d'un matériau semi-conducteur et une deuxième étape de traitement par polissage consistant à polir essentiellement un film métallique barrière avec la dispersion aqueuse pour polissage chimio-mécanique selon la revendication 5 ou 6, conduite après la première étape de traitement par polissage.
